# EUROPÄISCHE PATENTSCHRIFT

(11) **EP 1 219 417 B1**
(45) Veröffentlichungstag und Bekanntmachung des Hinweises auf die Patenterteilung: **17.06.2009**
(21) Anmeldenummer: 01129903.9
(22) Anmeldetag: 15.12.2001
(51) Int. Cl.: B41C 1/10, B41C 1/02, B41C 1/06, B41C 1/14

(54) **Maskenerstellung zur Herstellung einer Druckform**
Production of masks for the production of printing forms
Fabrication de masques pour la production de plaques d'impression

(30) Priorität: 21.12.2000 DE 10063819
(43) Veröffentlichungstag der Anmeldung: 03.07.2002
(73) Patentinhaber: manroland AG, 63075 Offenbach/Main (DE)
(72) Erfinder: Schneider, Josef, Dr., 86420 Diedorf (DE); Schuster, Alfons, 86199 Augsburg (DE); Stamme, Rainer, 86179 Augsburg (DE); Schönert, Michael, 86150 Augsburg (DE)
(74) Vertreter: Ulrich, Thomas

(56) Entgegenhaltungen:
- WO-A-97/44711
- DE-A- 4 117 127
- DE-A- 19 914 323
- US-A- 5 608 441

## Beschreibung

Die Erfindung betrifft eine Maskenerstellung zur Herstellung einer Druckform.

Es ist allgemein bekannt, dass in vielen technischen Bereichen Masken zur Oberflächenbehandlung (Leiterplattenherstellung) oder auch für Druck- (Tiefdruck, bei dem nicht Druckformen aufgebracht, sondern die Formzylinderoberflächen selbst als Druckformen präpariert werden) bzw. Lithografieprozesse verwendet werden. Das Ziel ist es dabei immer, mit einem Material, das andere Eigenschaften als ein Substrat, also eines Trägers eines hinsichtlich des Maskenmaterials anderen Stoffes, eine bestimmte Struktur (Maske) auf eben dem Substrat zu erzeugen. Die so entstandene Maske dient dann als Ausgangspunkt für weitere Prozesse. Sie soll z.B. das Substrat an bestimmten Stellen vor dem Einwirken anderer Substanzen schützen.

Der typische Ablauf einer bisherigen Maskenerstellung gliedert sich in die folgenden Schritte auf:
1. Erstellung eines Films mit der Strukturinformation,
2. Belichtung einer geeigneten photoempfindlichen Schicht auf einem Substrat durch diesen Film mittels einer geeigneten Lichtquelle,
3. Entwicklung/Reinigung zur Ausbildung der Struktur (Maske) auf dem Substrat. Anschliessend kann als weiterer Schritt beispielsweise Ätzen oder auch die direkte Verwendung der Maske beispielsweise als Druckform im Siebdruck folgen. Mittels dieser Maske werden dort alle nichtdruckenden Stellen abgedeckt. Die Druckfarbe findet nur an den offenen Stellen der Maske Durchlass.

Als eine Alternative zum voran beschriebenen Ablauf ist bereits auch bekannt:
1. Aufbringen einer energiesensitiven Schicht auf das Substrat,
2. direkte Belichtung, bzw. Ablation der Struktur mittels einer geeigneten bildinformationsvariablen Energiequelle wie Laser oder Elektronenstrahl,
3. Entwicklung/Reinigung zur Ausbildung der Struktur (Maske) auf dem Substrat, falls erforderlich.

Diese Alternative findet bereits in der Tiefdruckformherstellung Anwendung. Die Maske wird in der Regel auf den Tiefdruckzylinder übertragen, auf diesem dann in der Regel ein Gelatinerelief verbleibt, dessen Dicke dem Tonwert der Diapositive bzw. -negative entspricht. Beim Ätzen mit Eisenchlorid diffundiert das Eisensalz durch die Gelatine und löst Kupfer auf. Über die unterschiedliche Dicke des Reliefs, über die Wahl entsprechender Ätzbadkonzentrationen und über die Ätzdauer lässt sich die Ätztiefe weitgehend steuern

Hiervon ausgehend ist es die Aufgabe der Erfindung, den Ablauf einer Maskenerstellung, insbesondere zur Herstellung einer Druckform, zu vereinfachen und gleichzeitig die Güte der mittels einer Maske hergestellten Druckformen zu verbessern.

Diese Aufgabe wird erfindungsgemäß durch die Merkmale des Patentanspruchs 1 gelöst.

Für die Erstellung der Strukturinformation einer Maske wird eine Thermotransferfolie eingesetzt, die durch eine geeignete Zufuhrvorrichtung in Kontakt mit dem Substrat, d.h. der Oberfläche des Druckformträgers gebracht wird. Es kann eine energiesensitive Schicht auch durch direktes Beschichten des Substrats (z.B. durch Tauchbeschichtung, Aufrakeln, Aufsprühen, Aufwalzen oder Betonern mit Fest- oder Flüssigtoner), ggf. in Verbindung mit einem Nachtrocknungs- oder Aushärteschritt aufgebracht werden, auf dieser die Strukturinformation der Maske platziert wird.

Die Erstellung der Strukturinformation erfolgt vorzugsweise mittels Laserstrahlung, für Ablation ist vorzugsweise eine Leistungsdichte von mehr als 500 MW/m² ggf. gepulst vorgesehen. Dabei wird die Laserstrahlung bild- oder nichtbildmäßig auf geeignete Weise moduliert, um die gewünschte Maske zu erzeugen.

Beispielsweise aus der DE 198 11 031 A1 ist ein Verfahren und insbesondere eine Vorrichtung zur Herstellung eines Druckes unter Verwendung des laserinduzierten Thermotransfers mittels einer bandförmigen Transferfolie und eines Substratzylinders bekannt geworden. Die bekannte Vorrichtung umfasst einen Bandtransportmechanismus, der mit einer mit der einen oder mehrere (Laserdiodenarray) Laserstrahlen aussendenden Bebilderungseinheit gekoppelten Traversiereinheit zusammenwirkt. Damit ist die Transferfolie gleichförmig zur Bewegung über die Substratbreite eines Druckformzylinders bewegbar, wobei der mittels einer Steuerungseinheit in bekannter Weise entsprechend einem zu übertragenden Bild angesteuerte laserbasierte Thermodruckkopf bei jedem Bildpunkt Wärme auf die Transferfolie einleitet und damit eine punktuelle Übertragung der Beschichtung (Thermomaterial) der Transferfolie vornimmt und wobei über die Rotation des Substratzylinders und die zum Substratzylinder achsparallele Traversierung die komplette Substratoberfläche überstreichbar ist.

Im Falle einer direkt aufgebrachten energiesensitiven Schicht kann die Entwicklung/Reinigung der Schicht mit einer geeigneten Reinigungsvorrichtung evtl unter Zuhilfenahme von Reinigungsflüssigkeiten erfolgen, also Reinigung durch Flüssigkeits- oder Partikelstrahl, ggf. kombiniert, oder Reinigung durch Bürsten oder Reinigung mittels Waschtuch. Zusätzlich kann die Schicht nach Ausformung der Maske noch thermisch beaufschlagt werden, um ihre Chemikalienbeständigkeit, bzw. mechanischen Eigenschaften zu verbessern.

Das Verfahren auf dem der Erfindungsvorschlag also basiert, ist der laserinduzierte Thermotransfer, wie er zur Herstellung der löschbaren Offsetdruckformen beispielsweise beim Gegenstand der DE 44 30 555 C1 eingesetzt wird. Die Systemanordnung aus den Komponenten Laser und Bandstation, wie aus der DE 44 30 555 C1 oder der DE 198 11 031 A1 bekannt (Thermotransfer-Offpressaufbau), bildet das Vorbild für eine Vorrichtung zur Maskenherstellung.

Der laserinduzierte Thermotransfer bietet gegenüber herkömmlichen Verfahren zur Maskenerstellung den Vorteil, dass er sehr schnell und präzise ist. Durch den laserinduzierten Thermotransfer werden die Prozessschritte des Beschichtens und des Bebilderns zu einem Prozessschritt zusammengefasst. Dadurch können Zeit und Kosten eingespart werden.

Die Bebilderungsqualität des laserinduzierten Thermotransfers ist sehr hoch (Offsetqualität), so dass feinste Strukturen abgebildet werden können.

Das aus dem voran beschriebenen Stand der Technik bekannte Thermotransfermaterial, welches auf die herzustellende Druckform aufgebracht wird, ist geeignet, zur Maskenerstellung durch Belichtung, Auswaschung, bzw. Ätzung eingesetzt zu werden. Das Thermotransfermaterial ist opak (lichtbeständig), wasserfest und insbesondere säureresistent.

Das Thermotransfermaterial muss nicht gesondert aufgebracht werden. Auf dünnen Folienbändern aufgebracht, kommen bekanntlich vorkonfektionierte Bandkassetten zum Einsatz. Außerdem kann sowohl die Erstellung der Maske, als auch die Herstellung einer Druckform mittels dieser Maske innerhalb der Druckmaschine vorgenommen werden.

Weitere Merkmale und Vorteile ergeben sich aus den Unteransprüchen in Verbindung mit der Beschreibung.

Nachfolgend wird die Erfindung näher erläutert. In der zugehörigen Zeichnung zeigt schematisch, die
- Fig. 1: ein Maschinengestell mit Komponentenanordnung zur Maskenerstellung,
- Fig. 2: eine Maskenerstellung mittels laserinduziertem Thermotransfer zur Druckformherstellung,
- Fig. 3 bis 5: Details der Maskenerstellung zur Tiefdruckformherstellung,
- Fig. 6 bis 8: Details der Maskenerstellung zur Flexodruckformherstellung,
- Fig. 9 bis 11: Details der Maskenerstellung zur Siebdruckformherstellung und
- Fig. 12 bis 14: Details der Maskenerstellung zur galvanischen Siebdruckformherstellung.

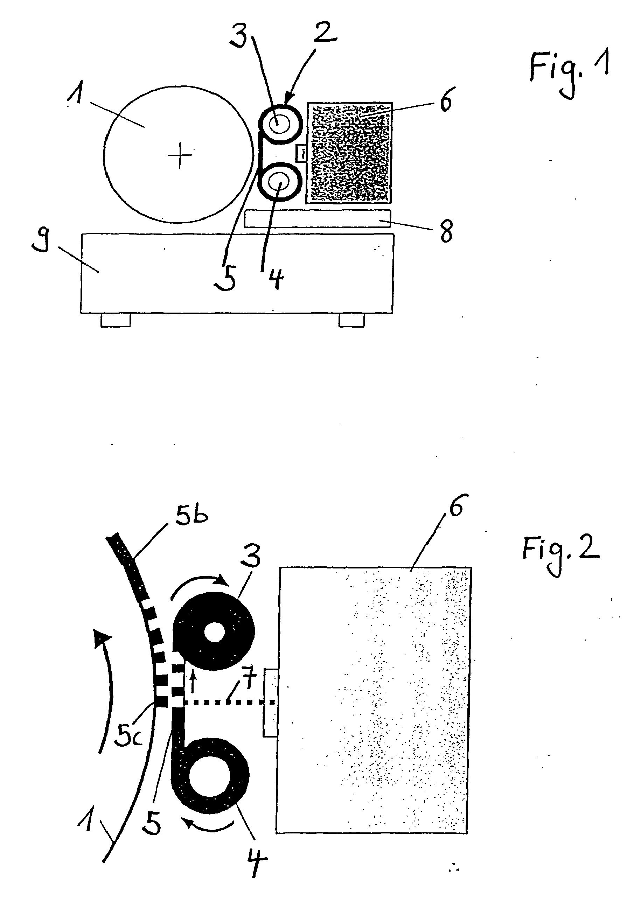

Fig. 1 (und Fig. 2) zeigt einen Druckformzylinder 1, auf dessen Oberfläche eine Maske erstellt werden soll. Ein Bandtransportmechanismus 2, eine Vorrats- 3 und eine Aufwickelrolle 4 umfassend, führt eine bandförmige Thermotransferfolie 5 nahe an der Oberfläche des Druckformzylinders 1, bzw. bringt diese in Kontakt mit der Oberfläche des Druckformzylinders 1. Eine Laser-Bebilderungseinheit 6 fokussiert eine oder mehrere Laserstrahlen 7 auf die Thermotransferfolie 5. Die Laser-Bebilderungseinheit 6 und der Bandführungsmechanismus 2 sind in bekannter Weise gemeinsam auf einer Traversiereinheit 8 angeordnet, mittels dieser sie in einem Maschinengestell 9 über die Breite des Druckformzylinders 1 bewegt werden können.

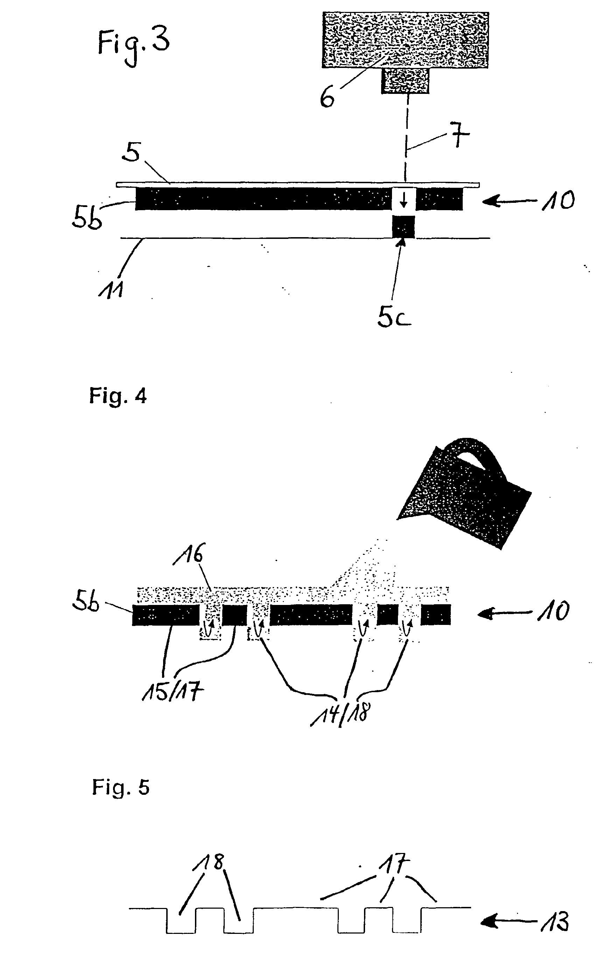

In Fig. 2 ist nochmals dargestellt, wie die Vorrichtung gemäss der Fig. 1 in einer Tiefdruckmaschine zum Einsatz kommt, um eine Ätzmaske 10 (Fig. 3, bzw. 4) mittels laserinduziertem Thermotransfer auf der Oberfläche 11 eines Tiefdruckzylinders zu erstellen, indem Thermotransfermaterial 5b als Bildinformation 5c, bzw. Strukturinformation für die Ätzmaske 10 übertragen wird.

Gemäss der Fig. 3 bis 5 kann also eine Maskenerstellung mittels laserinduziertem Thermotransfer zur Herstellung einer Tiefdruckform 13 verwendet werden. Dabei handelt es sich um ein Ätzverfahren, bei welchem in herkömmlicher Weise mittels Eisen-III-Chlorid (Fe3Cl) Bildinformationen auf einen Druckzylinder mit einer Kupferoberschicht geätzt werden können. In Fig. 3 ist der Vorgang der Maskenerstellung für eine Tiefdruckform angedeutet und es sind die gleichen Bezugszeichen für gleiche Teile der Fig. 1 und 2 verwendet.

Fig. 4 (und Fig. 3) zeigt den Ätzvorgang im Tiefdruck mit Hilfe einer erfindungsgemäß hergestellten Ätzmaske 10. Mit dieser Ätzmaske 10, die auf die Zylinderoberfläche 11 aufzubringen ist, wird eine Differenzierung hinsichtlich Bildstellen und Nicht-Bildstellen (Bildinformation 5c) vorgenommen. Die Ätzmaske 10 wird von der Transferfolie 5 in Form des Thermotransfermaterials 5b als Negativmaske aufgebracht, so dass die beabsichtigten Bildstellen 14 als freie und nicht abdeckende Bereiche erkennbar sind. Die Nicht-Bildstellen 15 müssen bedeckt und geschützt sein. Nach dem Aufbringen der bilddifferenzierenden Maske 10 kann die Tiefdruckform 13 geätzt werden, wobei durch das Aufbringen von Säure 16 die Zylinderoberfläche 11 an den Bildstellen 14, d.h. den ungeschützten Bereichen, durch den Ätzprozess angegriffen bzw. vertieft, und damit Tiefdrucknäpfchen 18 ausgebildet werden. Die Säure 16 greift durch eine chemische Reaktion das Oberflächenmaterial, im allgemeinen bei Tiefdruckformen das Kupfer, an und löst dieses auf.

Das Material 5b, welches die bilddifferenzierende Maske 10 bildet, muss beständig gegen Säure sein und darf von dieser nicht angegriffen werden. Durch diese Beständigkeit wird die Bilddifferenzierung bzw. die Bilderzeugung auf der Tiefdruckform 13 gewährleistet. Das Maskenmaterial 5b wird auch als Ätzresistenz oder Ätzreserve bezeichnet. Die Haftung des Maskenmaterials 5b auf der Druckformoberfläche 11 muss fest und gleichmäßig sein. Es muss gewährleistet sein, dass die Säure 16 die Maske 10 nicht unterlaufen bzw. unterfluten kann. Diese Haftungsfestigkeit garantiert gleichzeitig eine kantenscharfe und exakte Bilderzeugung, welches hauptsächlich bei Linien und Schriften von größter Bedeutung und Notwendigkeit ist. Die für den Tiefdruck notwendigen rakeltragenden Strukturen (Stege 17) müssen dabei über entsprechende Bilddatengenerierungen bei der Maskenerstellung durch die Laserbebilderung gewährleistet sein.

Für die Maskenerstellung mittels laserinduziertem Thermotransfer kommt allgemein ein Polymermaterial zum Einsatz, welches in dünnen Schichten auf einem Folienträger aufgebracht ist. Diese beschichtete Thermotransferfolie 5 ist wie eingangs beschrieben auf einer Vorratsrolle 3 aufgewickelt und wird über eine entsprechende Vorrichtung bei dem Vorgang der Maskenerstellung abgewickelt. Die Führung des Folienbandes 5 ist in der Art ausgerichtet, dass die mit dem Maskenmaterial 5b beschichtete Seite der Folie 5 der Oberfläche des Druckformzylinders 1 zugeordnet ist. In der Vorrichtung ist neben der Folienbandführung 2 ein Lasersystem 6 zur Bilderzeugung integriert. Dieses vorzugsweise diodengepumte YAG-Lasersystem 6 überträgt die Bildsignale von einem digitalen Datenbestand mittels energiereicher Laserimpulse auf die Rückseite der mit dem Maskenmaterial 5b beschichteten Folie 5. Der Abstand der Folie 5 zur Zylinderoberfläche muss dabei sehr gering sein, so dass das Maskenmaterial 5b sobald die energiereiche Laserstrahlung 7 auf die Folienrückseite trifft, von der Folienvorderseite mit ausreichender Exaktheit und Vollständigkeit auf die Oberfläche des Zylinders 1 transportiert werden kann.

Die Zylinderrotationsgeschwindigkeit und die Geschwindigkeit des Folienbandvorschubs werden von der Leistungsfähigkeit des Lasersystems bestimmt. Der seitliche Vorschub in paralleler Richtung der Zylinderachse wird durch die Anzahl der Laserdiodenarrays vorgegeben. Das Prinzip der rotativen Bebilderung mit seitlich traversierendem Vorschub gewährleistet die Möglichkeit einer nahtlosen Maskenerstellung auf der zu bearbeitenden Tiefdruckwalze.

Bei der laserinduzierten Maskenerstellung handelt es sich um ein autotypisches Bildaufbauverfahren, d.h. das die Bildinformation flächenvariabel bei gleichzeitiger Schichtdickenkonstanz aufgetragen wird. Die Maske muss zur erfolgreichen Verarbeitung beim Ätzprozess im Negativverfahren übertragen worden sein. Die Bildstellen 14, also die Tiefdrucknäpfchen 18, die auf der Tiefdruckform nach dem Ätzen vertieft liegen sollen, müssen nach der Maskierung erkennbar freiliegen, d.h. diese Bereiche dürfen von der Ätzmaske 10 nicht bedeckt sein. Die Nicht-Bildstellen 15 müssen von der Negativmaske erkennbar bedeckt werden. Die Fig. 5 zeigt eine solche geätze Tiefdruckform 13 mit bereits entfernter Ätzmaske und mit geätzen Tiefdrucknäpfchen 18 und Rasterstegen 17.

Der Vorteil dieses laserinduzierten Maskierverfahrens liegt in der gleichzeitigen Erstellung einer ätzresistenten Maske und der Übertragung der Bildinformationen. Durch dieses Verfahren wird die Trennung des Auftragens der Substratbeschichtung und des ablativen Bebilderns (also Maskenerstellung) aufgehoben. Die Bebilderung mittels Laserdiodenarrays erlaubt kurze Bebilderungszeiten, durch geringere erforderliche Energieleistungen und höheren Vorschubgeschwindigkeiten in seitlich paralleler Achsrichtung.

Ein weiterer Vorteil liegt in der Güte der Bebilderung begründet. Das Auflösungsvermögen einer laserinduzierten Bebilderung ist im Vergleich zu einer ausschließlich ablativen Laserbebilderung oder einer mechanischen Stichelgravur um ein Vielfaches höher. Die bekannten Schwächen des Tiefdrucks bei der Widergabe von kantenscharfen Linien und runden Schriftelementen können mit diesem Maskierverfahren mittels laserinduziertem Thermotransfer beseitigt werden.

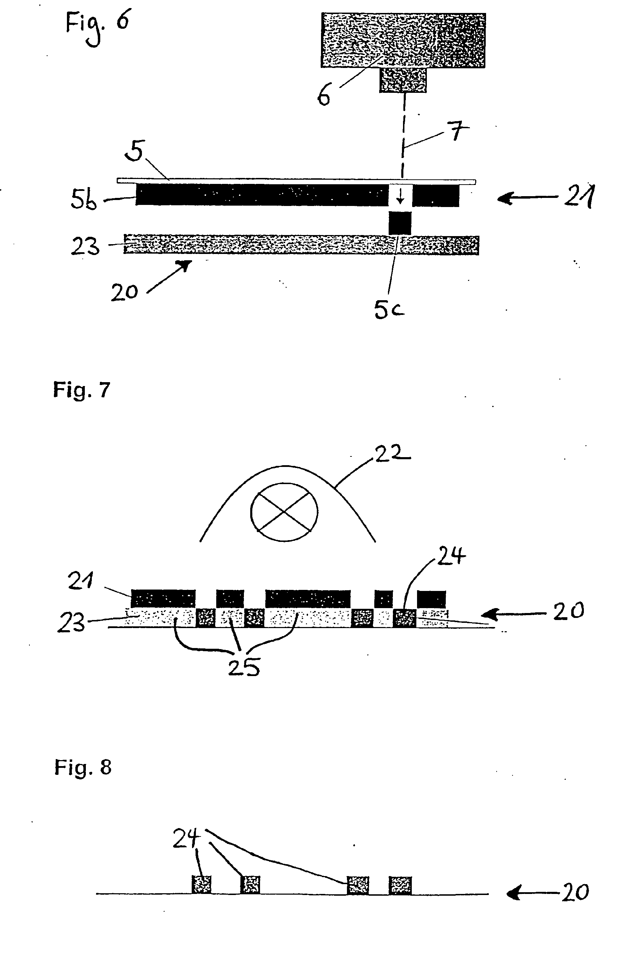

Die Fig. 6 deutet in einem weiteren Ausführungsbeispiel vorliegender Erfindung eine Maskenerstellung zur Herstellung einer Flexodruckform 20 an, Fig. 7 skizziert einen Kopiervorgang einer Flexodruckform 20 mittels Maske 21 und Fig. 8 zeigt eine entwickelte Flexodruckform 20 mit bereits entfernter Maske.

Gemäss den Fig. 6 bis 8 kann also die Maskenerstellung mittels laserinduziertem Thermotransfer des weiteren zur Herstellung einer Flexodruckform 20 verwendet werden. Dabei handelt es sich um ein Kopierverfahren, bei welchem die Bildinformationen mittels einer Kopiermaske 21 und energiereicher Strahlung (z.B. UV-Licht aus einer Kopierlampe 22, Fig. 7) auf eine lichtempfindliche Beschichtung 23 einer Flexodruckform 20 übertragen werden. Mit der Kopiermaske 21 wird eine Differenzierung hinsichtlich Bildstellen 24 und Nicht-Bildstellen 25 (Figs. 6 und 7) vorgenommen. Voraussetzung für den Kopierprozess zur Herstellung einer Flexodruckform 20 ist, dass der Flexodruckzylinder bzw. die Hülse (Sleeve), die auf diesen aufgeschoben werden kann, ebenso die Rohplatte, die auf einen entsprechenden Zylinder aufgespannt werden kann, mit einem lichtempfindlichen Material 23 vorbeschichtet worden ist.

Dieses Beschichten ist nicht Bestandteil der Flexodruckformherstellung, sondern wird von entsprechenden Herstellern bzw. Lieferanten als Rohmaterial vorgefertigt geliefert. Bei diesen Vorbeschichtungen gibt es sogenannte Negativ- bzw. Positivmaterialien, d.h. dass die Belichtung dieser Kopiermaterialien zum einen mittels einer Positivkopiermaske oder zum andern mittels einer Negativkopiermaske erfolgen kann.

Bei einer Negativkopie werden die von der Strahlung einer Kopierlampe 22 getroffenen Bereiche (Bildstellen 24) verändert (z.B. gehärtet), die nicht bestrahlten Bereiche (Nicht-Bildstellen 25) können in einem Entwicklungsprozess ausgewaschen werden (Fig. 8).

Somit resultieren die Bildstellen 24 aus den durchlässigen Bereichen der Negativmaske 21, die Nicht-Bildstellen 25 ergeben sich aus den abgedeckten Bereichen der Maske 21. Nach dem Entwickeln bzw. Auswaschen der mittels Negativkopie belichteten Flexodruckform 20 mit einer entsprechenden Lösung stehen die gehärteten Bildelemente 24 erhaben hervor (Fig. 8) und können als Flexodruckform 20 auf einem Flexodruckzylinder eingesetzt werden.

Bei einer Positivkopie werden die von der energiereichen Strahlung (z.B. UV-Licht) getroffenen Bereiche verändert (z.B. zerstört), die nicht bestrahlten Bereiche bleiben unverändert erhalten. Beim Entwicklungsprozess bzw. Auswaschen der mittels Positivkopie belichteten Rohplatte bzw. Zylinder werden die durch Bestrahlung zerstörten Bereiche mit einer entsprechenden Lösung ausgewaschen. Die nicht bestrahlten Stellen bleiben erhaben stehen und können ihrerseits als Flexodruckform eingesetzt werden.

Die mittels laserinduziertem Thermotransfer übertragene Maske 21 dient bei der Flexodruckformherstellung ausschließlich zur Übertragung der Bildinformationen 5c durch Kopie bzw. durch Bestrahlung mit energiereichem Licht (z.B. UV-Licht). Die Aufgabe der Kopiermaske 21 ist eine ausreichende Opazität bei der Bestrahlung zu gewährleisten. Die Bildinformationen müssen exakt und kantenscharf abgebildet werden können. Durchscheinen und Fehlstellen in der Maske 21 führen zu Fehlstellen auf der Flexodruckform 20. Für den Prozessschritt des Entwickelns bzw. Auswaschens wird die Kopiermaske 21 nicht mehr benötigt.

Die Ausführung der Maskenerstellung mittels laserinduziertem Thermotransfer gleicht der Ausführung der des Tiefdrucks bis auf den Umstand, dass bei der Maskenerstellung für die Flexodruckformherstellung sowohl Negativkopiemasken als auch Positivmasken zum Einsatz kommen können. Bei der Flexodruckformherstellung wird die Maske zur Belichtung mit energiereicher Strahlung (z.B. UV-Licht) eingesetzt und kommt bei der Übertragung von Bildinformationen nicht mit flüssigen Medien in Berührung. Die Vorrichtung zur Herstellung der Kopiermaske 21 zur Flexodruckformherstellung ist mit der der Tiefdruckmaskenerstellung identisch.

Der Vorteil hier liegt in der gleichzeitigen Erstellung einer opaken Kopiermaske und der Übertragung der Bildinformationen. Durch dieses Verfahren wird die Trennung des Maskierverfahrens und des ablativen Bebilderns aufgehoben. Somit können zwei Verfahrensschritte zur Maskierung einer Kopierform auf einen Prozessschritt verkürzt werden. Die Bebilderung mittels Laserdiodenarray erlaubt kurze Bebilderungszeiten durch geringere erforderliche Energieleistungen und höheren Vorschubgeschwindigkeiten in seitlich paralleler Achsrichtung. Ein weiterer Vorteil liegt in der Güte der Bebilderung begründet. Das Auflösungsvermögen einer laserinduzierten Bebilderung ist im Vergleich zu einer ausschließlich ablativen Laserbebilderung höher. Durch diese Vorteile resultieren einerseits Zeitersparnisse beim Prozessablauf und andererseits Kosteneinsparungen bei den Vorrichtungsaufbauten durch eingesparte Komponenten.

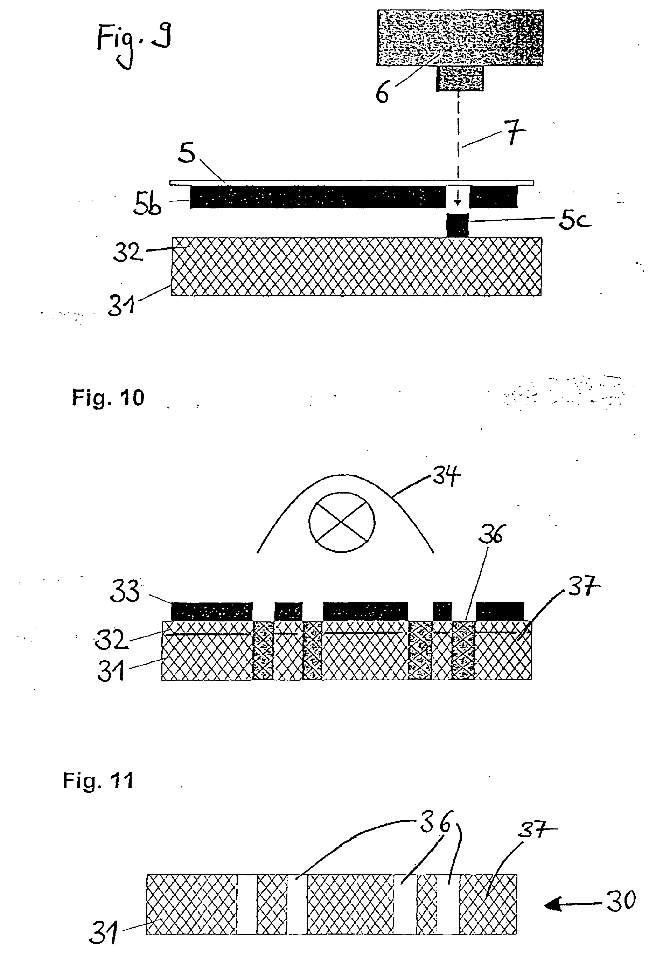

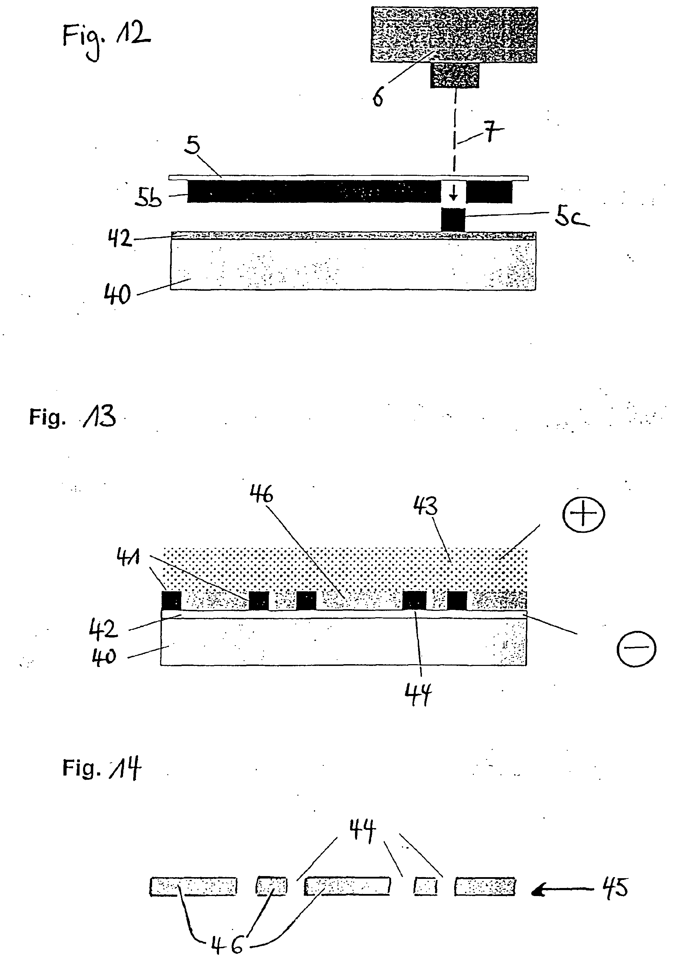

Gemäss den Fig. 9 bis 14 kann die Maskenerstellung mittels laserinduziertem Thermotransfer aber auch zur Herstellung einer Siebdruckform verwendet werden. So kann es sich entweder um ein Kopierverfahren (Fig. 9 bis 11) oder um ein Maskierverfahren für einen galvanischen Herstellungsprozess (Fig. 12 bis 14) handeln.

Bei dem Kopierverfahren für den Siebdruck (Fig. 9) werden sogenannte Siebdruckschablonen 30 (Siebdruckform, Fig. 11) hergestellt, wobei es sich meistens um eine netzartige Gewebestruktur 31 (Siebdruckgewebe) handelt, die in einem Rahmen oder in einem geeigneten Gestell eingespannt wird. Dieses netzartige Gewebe wird mit einer lichtempfindlichen Schicht 32 vollständig beschichtet und kann mit einer geeigneten Maske 33 zur Übertragung von Bildinformationen 5c mit energiereicher Strahlung (z.B. UV-Licht aus einer Kopierlampe 34) bestrahlt werden.

Die Fig 10 zeigt den Kopiervorgang zur Siebdruckformherstellung mittels Maske 33. Für den Kopierprozess können abhängig von dem zum Einsatz kommenden Maskenmaterial Positiv- oder Negativmasken eingesetzt werden. Bei Negativmasken werden die freiliegenden Bereiche der Maske zu Nicht-Bildstellen auf der Siebdruckform. Die von der Strahlung getroffenen Bereiche der lichtempfindlichen Schicht werden gehärtet und bleiben beim Entwickeln bzw. Auswaschen der Druckform erhalten. Nichtgehärtete Bereiche der lichtempfindlichen Schicht auf der Druckform werden ausgewaschen und bilden somit die durchlässigen Bildstellen auf der Siebdruckform. Bei Positivmasken 33 ist dieses Funktionsprinzip umgekehrt, d.h. die von der Strahlung getroffenen Bereiche (Bildstellen 36) werden zerstört und beim Entwickeln ausgewaschen. Hierbei werden die freiliegenden Bereiche zu Bildstellen 36, bzw. die abgedeckten Bereiche zu Nicht-Bildstellen 37 auf der Siebdruckform 30. Die mittels laserinduziertem Thermotransfer übertragene Maske 33 dient bei der Siebdruckformherstellung auf netzartigen Geweben 31 ausschließlich zur Übertragung der Bildinformationen durch Kopie bzw. durch Bestrahlung mit energiereichem Licht (z.B. UV-Licht).

Die Kopiermaske 33 muss eine ausreichende Opazität bei der Bestrahlung gewährleisten. Die Bildinformationen müssen exakt und kantenscharf abgebildet werden können. Durchscheinen und Fehlstellen in der Maske 33 führen zu Fehlstellen auf der Siebdruckform 30. Für den Prozessschritt des Entwickelns bzw. Auswaschens wird die Kopiermaske 33 nicht mehr benötigt.

Gemäss der Fig. 12 wird bei dem galvanischen Herstellungsprozess einer Siebdruckform (45, Fig. 14) die Maskenerstellung mittels laserinduziertem Thermotransfer dazu verwendet, um auf einem Zylinder (Grundzylinder 40) mit einer metallischen Oberfläche (Trennschicht aus Metall 42) eine Maske (positiv) 41 zu verankern, die die Bildinformationen in Bild- 44 bzw. Nicht-Bildstellen 46 trennt. Der metallische Zylinder (Grundzylinder 40, evt. Mit Trennschicht 42) wird mit der entsprechenden Maske 41 einem elektrolytischem Bad (Elektrolyt 43) ausgesetzt. Das Thermotransfermaterial 5b, 5c der Maske 41 dient dabei als Isolator, so dass an den Stellen bzw. Bereichen (Bildstellen 44), an denen sich die Maske 41 auf der Oberfläche (Trennschicht 42) des Grundzylinders 40 befindet, keine elektrische Ladung fließen kann (die metallische Trennschicht 42 ist negativ, der Elektrolyt 43 ist positiv geladen, Fig. 13). Somit kann an diesen durch die Maske 41 abgedeckten Stellen 44 kein Metallniederschlag stattfinden, d.h. die Wirkung des Absetzens von Metall (z.B. Kupfer, Nickel) durch das Elektrolytbad kann durch diese Maskierung bildmäßig gesteuert werden. Nach Abschluss des vollständigen Elektrolytprozesses (galvanischer Herstellungsprozesses) kann beispielsweise eine Hülse (Sleeve) von dem metallischen Zylinder (Grundzylinder 40) abgezogen werden, welche dann als Siebdruckform 45 nutzbar ist. An den Stellen 44, an denen die Positivmaske 41 auf dem Grundzylinder 40, 42 die Oberfläche abgedeckt hat, sind auf der Siebdruckform 45 (Hülse) entsprechende Löcher bzw. Bildstellen 41 vorhanden (Fig. 11). Diese Löcher dienen beim Siebdruck als farbführende Stellen (Farbdurchlass des Siebes), durch die die Farbe mit entsprechenden Rakeln auf die Bedruckstoffe geführt werden kann.

Die Maskenerstellung mittels laserinduzierten Thermotransfer dient bei diesem Siebdruckformherstellungsprozess als bilddifferenzierende Galvanikmaske 41. Die Maske 41 wird dabei einem flüssigen Elektrolytbad 43 ausgesetzt und muss gegen Anlösen und Unterlaufen resistent sein. Die Bildinformationen müssen exakt und kantenscharf abgebildet werden können. Die für den Siebdruck notwendigen rakeltragenden Strukturen müssen dabei über entsprechende Bilddatengenerierung bei der Maskenerstellung durch die Laserbebilderung gewährleistet sein.

Die Ausführung der voran beschriebenen Maskenerstellung gleicht der Ausführung des anfangs beschriebenen Tiefdrucks bis auf den Umstand, dass bei der Maskenerstellung für die Siebdruckformherstellung auf netzartigen Geweben sowohl Negativkopiermasken als auch Positivkopiermasken zum Einsatz kommen können. Bei der Siebdruckformherstellung auf Geweben wird die Maske zur Belichtung mit energiereichen Strahlen (z.B. UV-Licht) eingesetzt und kommt bei der Übertragung von Bildinformationen nicht mit flüssigen Medien in Berührung. Bei der galvanischen Siebdruckformherstellung werden Positivmasken mittels laserinduziertem Thermotransfer hergestellt. Dabei kommt die Maskierung mit flüssigen Medien (Elektrolytbäder) in Berührung. Die Vorrichtung zur Herstellung einer Kopiermaske für die Siebdruckformherstellung ist allerdings mit der Vorrichtung für die Tiefdruckmaskenerstellung identisch.

Der Vorteil dieses laserinduzierten Maskierverfahrens für die Siebdruckformherstellung liegt wiederum in der gleichzeitigen Erstellung einer Maske und der Übertragung der Bildinformationen. Durch dieses Verfahren wird die Trennung des Maskierverfahrens und des ablativen Bebilderns aufgehoben. Somit können zwei Verfahrensschritte zur Maskierung einer Kopierform bzw. einer galvanischen Grundform auf einen Prozessschritt verkürzt werden. Die Bebilderung mittels Laserdiodenarrays erlaubt kurze Bebilderungszeiten, durch geringere erforderliche Energieleistungen und höheren Vorschubgeschwindigkeiten in seitlich paralleler Achsrichtung. Ein weiterer Vorteil liegt in der Güte der Bebilderung begründet. Das Auflösungsvermögen einer laserinduzierten Bebilderung ist im Vergleich zu einer ausschließlich ablativen Laserbebilderung höher. Durch diese Vorteile resultieren einerseits Zeitersparnisse beim Prozessablauf und andererseits Kosteneinsparungen bei den Vorrichtungsaufbauten durch eingesparte Komponenten.

### Bezugszeichenliste

- 1: Druckformzylinder (Druckformträger)
- 2: Bandtransportmechanismus
- 3: Vorratsrolle
- 4: Aufwickelrolle
- 5: Thermotransferfolie
- 5b: Thermotransfermaterial
- 5c: Bildinformation (Strukturinformation)
- 6: Laser-Bebilderungseinheit
- 7: Laserstrahl
- 8: Traversiereinheit
- 9: Maschinengestell
- 10: Ätzmaske (Tiefdruck)
- 11: Tiefdruckzylinderoberfläche (Druckformträger)
- 13: Tiefdruckform
- 14: Bildstellen (Tiefdruck)
- 15: Nicht-Bildstellen (Tiefdruck)
- 16: Säure
- 17: Rasterstege
- 18: Tiefdrucknäpfchen
- 20: Flexodruckform
- 21: Kopiermaske (Flexodruck)
- 22: Kopierlampe
- 23: Lichtempfindliche Beschichtung (Druckformträger)
- 24: Bildstellen (Flexodruck)
- 25: Nicht-Bildstellen (Flexodruck)
- 30: Siebdruckschablone (Siebdruckform)
- 31: Siebdruckgewebe (Druckformträger)
- 32: Lichtempfindliche Beschichtung
- 33: Kopiermaske (Siebdruck)
- 34: Kopierlampe
- 36: Bildstellen (Siebdruck)
- 37: Nicht-Bildstellen (Siebdruck)
- 40: Grundzylinder (Siebdruck, Druckformträger)
- 41: Maske, positiv (Siebdruck)
- 42: Trennschicht
- 43: Elektrolyt
- 44: Bildstelle (Farbdurchlass des Siebes)
- 45: Siebdruckform
- 46: Nicht-Bildstelle (Stegstruktur des Siebes)

## Patentansprüche

1. Verfahren zur Herstellung einer Tief- (13), Flexo- (20) oder Siebdruckform (30, 45) unter Verwendung des laserinduzierten Thermotransfers, bei dem ein Polymermaterial (5b) für eine Maskenerstellung zum Einsatz kommt, welches in dünnen Schichten auf einen Folienträger (5) aufgebracht ist, der in Kontakt mit einem Druckformträger (11, 31, 40) gebracht wird
und mittels einer Laserbebilderungseinheit (6) zur Ablation des Polymermaterials (5b) die Strukturinformation (5c) einer Ätz- oder Kopiermaske (10, 33, 41) in Form einer laserinduzierten Bebilderung auf die Oberfläche des Druckformträgers (11, 31, 40) direkt aufgebracht wird
und diese Maske (10, 33, 41) zur Differenzierung hinsichtlich Bildstellen (14, 36, 44) und Nicht-Bildstellen (15, 37, 46) direkt auf dem Druckformträger (11, 31,40)
als Negativmaske, bei der die Nicht-Bildstellen bedeckt sind, oder als Positivmaske, bei der die Bildstellen abgedeckt werden, weiter verwendet wird.

2. Verfahren nach Anspruch 1, **dadurch gekennzeichnet, dass** zur Herstellung der Tiefdruckform (13) auf dem Druckformträger (11) die Ätzmaske (10) in Form einer Negativmaske erstellt wird und durch Säureauftrag (16) Tiefdrucknäpfchen (18) geätzt werden.

3. Verfahren nach Anspruch 1, **dadurch gekennzeichnet, dass** bei der laserinduzierten Bebilderung ein autotypisches Bilddatenverfahren durchgeführt wird, so dass die Strukturinformation (5c) der Maske (10, 33, 41) flächenvariabel bei gleichzeitiger Schichtdickenkonstanz aufgetragen wird.

4. Verfahren nach Anspruch 1, **dadurch gekennzeichnet, dass** zur Herstellung der Flexodruckform (20) eine Kopiermaske (21) auf einer lichtempfindlichen Beschichtung (23) des Druckformträgers erstellt wird, so dass mittels einer Kopierlampe (22) eine Differenzierung hinsichtlich Bildstellen (24) und Nicht-Bildstellen (25) auf der lichtempfindlichen Beschichtung (23) vorgesehen werden kann.

5. Verfahren nach Anspruch 1, **dadurch gekennzeichnet, dass** zur Herstellung der Siebdurckform (30) eine netzartige Gewebestruktur (31) mit einer lichtempfindlichen Schicht (32) vollständig beschichtet wird, die Schicht (32) mit der Strukturinformation (5c) einer Kopiermaske (33) belegt wird und mittels einer Kopierlampe (34) eine Differenzierung hinsichtlich Bildstellen (36) und Nicht-Bildstellen (37) vorgenommen wird.

6. Verfahren nach Anspruch 1, **dadurch gekennzeichnet, dass** zur Herstellung der Siebdruckform (45) auf der Oberfläche eines metallischen Druckformträgers (40) eine Differenzierung hinsichtlich Bildstellen (44) und Nicht-Bildstellen (46) mittels eines Elektrolyten (43) vorgenommen wird, wobei die Maske (41) als Isolator dient und so eine Positivmaske ist.

7. Verwendung des laserinduzierten Thermotransfers nach einem der vorangehenden Ansprüchen, **dadurch gekennzeichnet, dass** sowohl die Erstellung der Maske, als auch die Herstellung einer Druckform mittels dieser Maske innerhalb der Druckmaschine vorgenommen wird.

## Claims

1. A method for the production of a gravure printing forme (13), a flexographic printing forme (20) or a screen printing forme (30, 45) using laser-induced thermotransfer, in which for mask generation a polymer material (5b) is employed that is applied in thin layers to a foil carrier (5) which is brought into contact with a printing-forme carrier (11, 31, 40),
and by means of a laser-imaging unit (6) for the ablation of the polymer material (5b) the structure information (5c) of an etching or copying mask (10, 33, 41) is applied directly in the form of laser-induced imaging to the surface of the printing-forme carrier (11, 31, 40),
and this mask (10, 33, 41) for the purposes of differentiation with regard to image areas (14, 36, 44) and non-image areas (15, 37, 46) directly on the printing-forme carrier (11, 31, 40)
is used further as a negative mask, in which the non-image areas are covered, or as a positive mask, in which the image areas are uncovered.

2. A method according to claim 1, **characterised in that** in order to produce the gravure printing forme (13) on the printing-forme carrier (11) the etching mask (10) is generated in the form of a negative mask and gravure printing cells (18) are etched by means of the application of acid (16).

3. A method according to claim 1, **characterised in that** during the laser-induced imaging an autotypical image-data method is carried out so that the structure information (5c) of the mask (10, 33, 41) is applied in a variable area manner with simultaneous constancy of layer thickness.

4. A method according to claim 1, **characterised in that** in order to produce the flexographic printing forme (20) a copying mask (21) is generated on a light-sensitive coating (23) of the printing-forme carrier so that by means of a copying lamp (22) it is possible to provide differentiation with regard to image areas (24) and non-image areas (25) on the light-sensitive coating (23).

5. A method according to claim 1, **characterised in that** in order to produce the screen printing forme (30) a net-like woven-fabric structure (31) is completely coated with a light-sensitive layer (32), the layer (32) is overlaid with the structure information (5c) of a copying mask (33), and by means of a copying lamp (34) differentiation with regard to image areas (36) and non-image areas (37) is effected.

6. A method according to claim 1, **characterised in that** in order to produce the screen printing forme (45) on the surface of a metallic printing-forme carrier (40) differentiation with regard to image areas (44) and non-image areas (46) is effected by means of an electrolyte (43), in which case the mask (41) is used as an insulator and is thus a positive mask.

7. Use of the laser-induced thermotransfer according to one of the preceding claims, **characterised in that** not only the generation of the mask, but also the production of a printing forme by means of this mask, is effected within the printing machine.

## Revendications

1. Procédé de fabrication d'une forme pour l'impression en taille douce (13), l'impression flexographique (20) ou l'impression par sérigraphie (30, 45) en utilisant le thermotransfert induit par laser selon lequel
on utilise un polymère (5b) pour la fabrication du masque, ce polymère étant appliqué en couches minces sur un film de support (5) mis en contact avec un support de forme d'impression (11, 31, 40),
on utilise une unité d'imagerie laser (6) pour l'ablation du polymère (5b) appliquant directement l'information de structure (5c) d'un masque de gravure ou de copie (10, 33, 41) sous la forme d'une imagerie induite par laser à la surface du support de forme d'impression (11, 31, 40),
le masque (10, 33, 41) est utilisé pour différencier les points-images (14, 36, 44) et les points-non-images (15, 37, 46), directement sur le support de forme d'impression (11, 31, 40), et
ce masque est utilisé comme masque négatif consistant à couvrir les points-non-images ou comme masque positif selon lequel on couvre les points-images.

2. Procédé selon la revendication 1,
**caractérisé en ce que**
pour fabriquer la forme d'impression en taille douce (13) on réalise le masque de gravure (10) sous la forme d'un masque négatif sur le support de forme d'impression (11) et par application d'acide (16) on grave des cavités en taille douce (18).

3. Procédé selon la revendication 1,
**caractérisé en ce que**
pour l'imagerie induite par laser on applique un procédé de données d'images autotypiques de façon à appliquer l'information de structure (5c) du masque (10, 33, 41) par les surfaces variables tout en assurant simultanément une constance d'épaisseur de couche.

4. Procédé selon la revendication 1,
**caractérisé en ce que**
pour fabriquer la forme d'impression de flexographie (20) on établit un masque de copie (21) sur un revêtement photosensible (23) du support de forme d'impression de façon qu'à l'aide d'une lampe de copie (22) on puisse différentier les points-images (24) et les points-non-images (25) sur le revêtement photosensible (23).

5. Procédé selon la revendication 1,
**caractérisé en ce que**
pour réaliser la forme d'impression de sérigraphie (30) on réalise un revêtement complet d'une structure de tissu (31) en forme de filet avec une couche photosensible (32), on charge la couche (32) de l'information de structure (5c) d'un masque de copie (33) et à l'aide d'une lampe de copie (34) on réalise la différentiation concernant les points images (36) et les points-non-images (37).

6. Procédé selon la revendication 1,
**caractérisé en ce que**
pour réaliser la forme d'impression par sérigraphie (45) on réalise à la surface d'un support métallique de forme d'impression (40) une différentiation pour les points-images (44) et les points-non-images (46) à l'aide d'un électrolyte (43), le masque (41) servant d'isolant et réalisant ainsi un masque positif.

7. Utilisation du thermotransfert induit par laser selon l'une des revendications précédentes,
**caractérisée en ce qu'**
on effectue à la fois l'établissement du masque et aussi l'établissement d'une forme d'impression à l'aide du masque dans la machine d'impression.
